# EUROPEAN PATENT SPECIFICATION

(11) **EP 4 167 478 B1**
(45) Date of publication and mention of the grant of the patent: **02.12.2026**
(21) Application number: 22200322.0
(22) Date of filing: 07.10.2022
(51) Int. Cl.: H03F 1/02, H03F 3/195, H03F 3/213, H03F 3/24, H03F 3/45

(54) **MULTI-VOLTAGE GENERATION CIRCUIT**
MEHRSPANNUNGSGENERATORSCHALTUNG
CIRCUIT DE GÉNÉRATION DE TENSIONS MULTIPLES

(30) Priority: 14.10.2021 US 202163255651 P; 14.10.2021 US 202163255649 P; 16.09.2022 US 202217946224
(43) Date of publication of application: 19.04.2023
(73) Proprietor: Qorvo US, Inc., Greensboro, NC 27409 (US)
(72) Inventor: KHLAT, Nadim, 31770 Colomiers (FR)
(74) Representative: D Young & Co LLP

(56) References cited:
- US-A1- 2020 382 062
- US-A1- 2021 288 615

## Description

### Cited Art

US2020/382062A1 relates to 'Envelope tracking amplifier apparatus'. US2021/288615A1 relates to 'Fast-switching average power tracking power management integrated circuit'.

### Field of the Disclosure

The present disclosure is related to a power management circuit operable to maintain multiple voltages simultaneously.

### Background

Mobile communication devices have become increasingly common in current society for providing wireless communication services. The prevalence of these mobile communication devices is driven in part by the many functions that are now enabled on such devices. Increased processing capabilities in such devices means that mobile communication devices have evolved from being pure communication tools into sophisticated mobile multimedia centers that enable enhanced user experiences.

The redefined user experience requires higher data rates offered by such advanced wireless communication technologies as fifth-generation new-radio (5G-NR). To achieve higher data rates, a mobile communication device may employ a power amplifier(s) to amplify a radio frequency (RF) signal(s) (e.g., maintaining sufficient energy per bit) before transmission. Given that the power amplifier(s) requires a supply voltage(s) for operation, a power management integrated circuit (PMIC) is thus required to generate and provide the supply voltage(s) to the power amplifier(s).

Given that the PMIC often needs to concurrently generate multiple supply voltages for multiple power amplifiers, the PMIC typically includes multiple direct-current to direct-current (DC-DC) converters for modulating the multiple supply voltages. Having the multiple DC-DC converters will inevitably increase footprint of the PMIC, thus making it difficult to fit the PMIC into an increasing miniaturized electronic device(s) such as a smartphone and smart gadgets. Hence, it is desirable to reduce the number of DC-DC converters in the PMIC to help reduce the footprint of the PMIC.

### Summary

Particular embodiments are set out in the independent claims. Various optional examples are set out in the dependent claims. Embodiments of the disclosure relate to a multi-voltage generation circuit. More specifically, the multi-voltage generation circuit includes multiple voltage modulation circuits that are configured to generate and maintain multiple modulated voltages. In a non-limiting example, the multiple modulated voltages can be used for amplifying multiple radio frequency (RF) signals concurrently. Contrary to using multiple direct-current (DC) to DC (DC-DC) converters for generating the multiple modulated voltages, the voltage modulation circuits are configured to share a single current modulation circuit based on time-division. By sharing a single current modulation circuit among the multiple voltage modulation circuits, it is possible to concurrently support multiple load circuits (e.g., power amplifier circuits) with significantly reduced footprint.

In one aspect, a multi-voltage generation circuit is provided. The multi-voltage generation circuit includes a current modulation circuit configured to sequentially generate multiple low-frequency currents in each of one or more operation periods based on a plurality of duty cycles, respectively. The multi-voltage generation circuit also includes multiple voltage modulation circuits. Each of the multiple voltage modulation circuits includes a respective one of multiple voltage amplifiers configured to generate a respective one of multiple modulated initial voltages based on a respective one of multiple modulated target voltages. Each of the multiple voltage modulation circuits also includes a respective one of multiple offset capacitors each modulated to a respective one of multiple offset voltages by a respective one of the multiple low-frequency currents such that the respective one of the multiple offset voltages can raise the respective one of the multiple modulated initial voltages to thereby generate a respective one of multiple modulated voltages. The multi-voltage generation circuit also includes a control circuit. The control circuit is configured to determine an order for generating the multiple low-frequency currents in each of the one or more operation periods. The control circuit is also configured to generate the plurality of duty cycles in accordance with the determined order and provide each of the plurality of duty cycles to the current modulation circuit to thereby cause the current modulation circuit to sequentially generate the multiple low-frequency currents in each of the one or more operation periods according to the determined order.

In another aspect, a method for generating multiple low-frequency currents is provided. The method includes determining an order for generating multiple low-frequency currents in each of one or more operation periods. The method also includes generating a plurality of duty cycles in accordance with the determined order and sequentially generating the multiple low-frequency currents in each of the one or more operation periods according to the determined order.

In another aspect, a multi-voltage power management circuit is provided. The multi-voltage power management circuit includes multiple power amplifier circuits. The multiple power amplifier circuits are configured to concurrently amplify multiple radio frequency (RF) signals based on multiple modulated voltages, respectively. The multi-voltage power management circuit also includes a multi-voltage generation circuit. The multi-voltage generation circuit includes a current modulation circuit configured to sequentially generate multiple low-frequency currents in each of one or more operation periods based on a plurality of duty cycles, respectively. The multi-voltage generation circuit also includes multiple voltage modulation circuits. Each of the multiple voltage modulation circuits includes a respective one of multiple voltage amplifiers configured to generate a respective one of multiple modulated initial voltages based on a respective one of multiple modulated target voltages. Each of the multiple voltage modulation circuits also includes a respective one of multiple offset capacitors each modulated to a respective one of multiple offset voltages by a respective one of the multiple low-frequency currents such that the respective one of the multiple offset voltages can raise the respective one of the multiple modulated initial voltages to thereby generate a respective one of the multiple modulated voltages. The multi-voltage generation circuit also includes a control circuit. The control circuit is configured to determine an order for generating the multiple low-frequency currents in each of the one or more operation periods. The control circuit is also configured to generate the plurality of duty cycles in accordance with the determined order and provide each of the plurality of duty cycles to the current modulation circuit to thereby cause the current modulation circuit to sequentially generate the plurality of low-frequency currents in each of the one or more operation periods according to the determined order.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 is a schematic diagram of an example multi-voltage power management circuit wherein a multi-voltage generation circuit is configured according to embodiments of the present disclosure to concurrently generate and maintain multiple modulated voltages by sharing a current modulation circuit;
Figure 2 illustrates an example operation of a voltage modulation circuit for generating and maintaining any one of the multiple modulated voltages during an operation period(s);
Figure 3 provides an example illustration of a time-division scheme that can be employed by the multi-voltage generation circuit in Figure 1 for concurrently generating and maintaining the multiple modulated voltages;
Figure 4 is a schematic diagram of an example control circuit that can be provided in the multi-voltage generation circuit in Figure 1 for generating and maintaining the multiple modulated voltages concurrently;
Figure 5 provides an example illustration as to how the control circuit in Figure 4 can determine the time-division scheme in Figure 3 based on a current generation order; and
Figure 6 is a flowchart of an example process for generating multiple low-frequency currents to cause the multi-voltage generation circuit in Figure 1 to generate and maintain the modulated voltages.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to a multi-voltage generation circuit. More specifically, the multi-voltage generation circuit includes multiple voltage modulation circuits that are configured to generate and maintain multiple modulated voltages. In a non-limiting example, the multiple modulated voltage can be used for amplifying multiple radio frequency (RF) signals concurrently. Contrary to using multiple direct-current (DC) to DC (DC-DC) converters for generating the multiple modulated voltages, the voltage modulation circuits are configured to share a single current modulation circuit based on time-division. By sharing a single current modulation circuit among the multiple voltage modulation circuits, it is possible to concurrently support multiple load circuits (e.g., power amplifier circuits) with significantly reduced footprint.

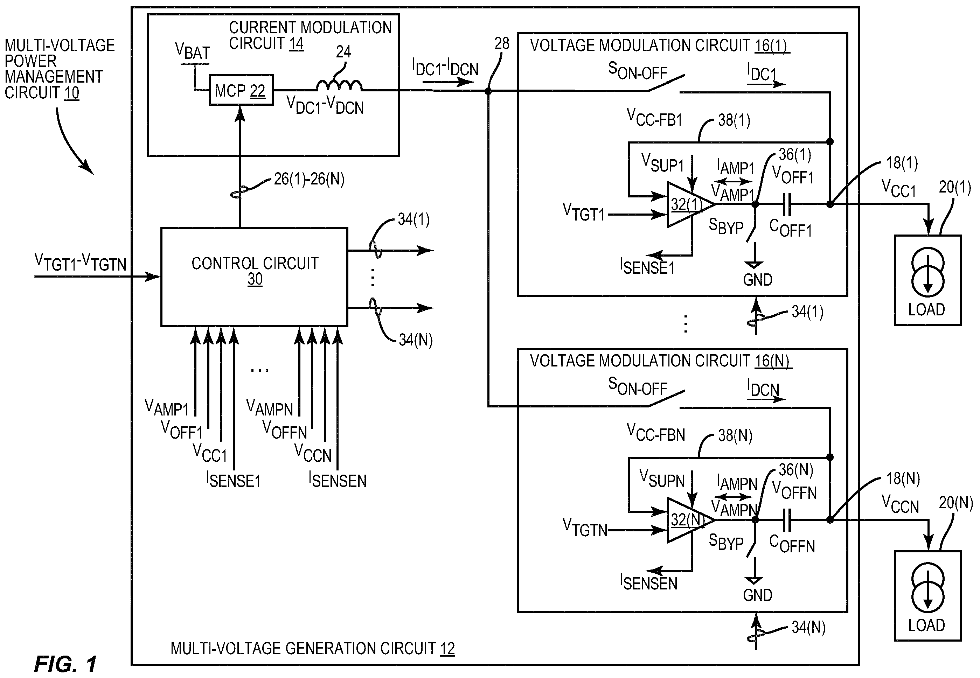

In this regard, Figure 1 is a schematic diagram of an example multi-voltage power management circuit 10 wherein a multi-voltage generation circuit 12 is configured according to embodiments of the present disclosure to concurrently generate and maintain multiple modulated voltages V_{CC1}-V_{CCN} by sharing a current modulation circuit 14. Herein, the multi-voltage generation circuit 12 includes multiple voltage modulation circuits 16(1)-16(N) each configured to share the current modulation circuit 14 based on time-division to thereby generate and maintain a respective one of the modulated voltages V_{CC1}-V_{CCN}. The voltage modulation circuits 16(1)-16(N) are configured to output the modulated voltages V_{CC1}-V_{CCN} via multiple voltage outputs 18(1)-18(N), respectively.

In an embodiment, the voltage outputs 18(1)-18(N) are coupled to multiple load circuits 20(1)-20(N), respectively. In this regard, the voltage modulation circuits 16(1)-16(N) are configured to concurrently provide and maintain the modulated voltages V_{CC1}-V_{CCN} for the load circuits 20(1)-20(N). In a non-limiting example, the load circuits 20(1)-20(N) can be power amplifier circuits each configured to amplify a respective one of multiple RF signals (not shown) based on a respective one of the modulated voltages V_{CC1}-V_{CCN}. Understandably, the load circuits 20(1)-20(N) can also be any other active circuits that operate based on a voltage. Further, the load circuits 20(1)-20(N) may also include a mixture of power amplifier circuits and other types of active circuits. By sharing the current modulation circuit 14 among the voltage modulation circuits 16(1)-16(N), the multi-voltage power management circuit 10 can concurrently support the load circuits 20(1)-20(N) with significantly reduced footprint.

According to an embodiment of the present disclosure, the current modulation circuit 14 includes a multi-level charge pump (MCP) 22 and a power inductor 24. The MCP 22 is configured to operate based on a plurality of duty cycles 26(1)-26(N) to generate a plurality of low-frequency voltages V_{DC1}-V_{DCN} (e.g., DC voltages), each as a function of a battery voltage V_{BAT}. In a non-limiting example, the MCP 22 can be a DC-DC buck-boost converter that can operate in a buck mode and/or a boost mode. Herein, the MCP 22 is configured to generate each of the low-frequency voltages V_{DC1}-V_{DCN} at 0×V_{BAT} or 1×V_{BAT} when operating in the buck mode, or at 2×V_{BAT} when operating in the boost mode. Understandably, the MCP 22 can toggle between 0×V_{BAT}, 1 ×V_{BA}, and/or 2×V_{BAT} based on a respective one of the duty cycles 26(1)-26(N) to thereby generate each of the low-frequency voltages V_{DC1}-V_{DCN} at any desired voltage level. In other words, it is possible to adjust the low-frequency voltages V_{DC1}-V_{DCN} by simply adjusting the duty cycles 26(1)-26(N).

The power inductor 24 is coupled between the MCP 22 and a common node 28. Herein, the power inductor 24 is configured to induce a multiple low-frequency current I_{DC1}-I_{DCN} (e.g., a DC current) based on the low-frequency voltages V_{DC1}-V_{DCN}, respectively. Given that the low-frequency voltages V_{DC1}-V_{DCN} can be adjusted based on the duty cycles 26(1)-26(N), the low-frequency currents I_{DC1}-I_{DCN} can likewise be adjusted based on the duty cycles 26(1)-26(N).

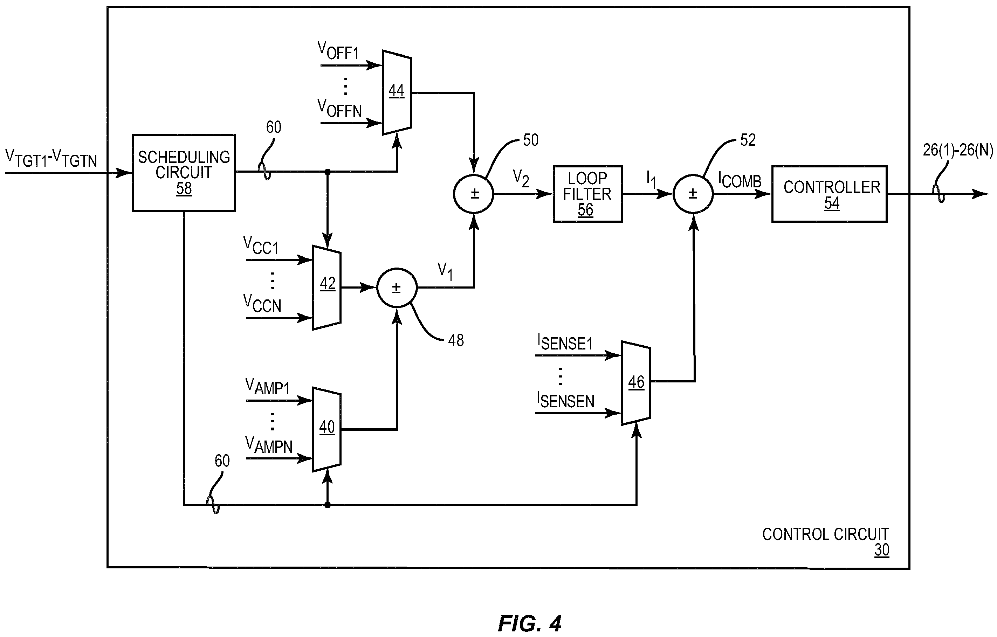

In an embodiment, the multi-voltage generation circuit 12 further includes a control circuit 30, which can be a field-programmable gate array (FPGA) or an application-specific integrated circuit (ASIC), as an example. As further discussed in Figure 4, the control circuit 30 can be configured to adjust each of the duty cycles 26(1)-26(N) based on a variety of feedback provided by the voltage modulation circuits 16(1)-16(N). In addition, the control circuit 30 is further configured to determine a time-division schedule whereby the voltage modulation circuits 16(1)-16(N) can share the current modulation circuit 14.

In an embodiment, each of the voltage modulation circuits 16(1)-16(N) includes a respective one of multiple voltage amplifiers 32(1)-32(N), a respective one of multiple offset capacitors C_{OFF1}-C_{OFFN}, a respective bypass switch S_{BYP}, and a respective on-off switch S_{ON-OFF}. In a non-limiting example, the control circuit 30 can control (e.g., toggle) the bypass switch S_{BYP} and the on-off switch S_{ON-OFF} in each of the voltage modulation circuits 16(1)-16(N) via a respective one of multiple control signals 34(1)-34(N).

Each of the voltage amplifiers 32(1)-32(N) is configured to generate a respective one of multiple modulated initial voltages V_{AMP1}-V_{AMPN} at a respective one of multiple outputs 36(1)-36(N) based on a respective one of multiple modulated target voltages V_{TGT1}-V_{TGTN} and a respective one of multiple supply voltages V_{SUP1}-V_{SUPN}. For example, the voltage amplifier 32(1) generates the modulated initial voltage V_{AMP1} at the output 36(1) of the voltage amplifier 32(1) based on the modulated target voltage V_{TGT1} and the supply voltage V_{SUP1}, and the voltage amplifier 32(N) generates the modulated initial voltage V_{AMPN} at the output 36(N) of the voltage amplifier 32(N) based on the modulated target voltage V_{TGTN} and the supply voltage V_{SUPN}.

In an embodiment, each of the voltage amplifiers 32(1)-32(N) may be configured to source or sink a respective one of multiple high-frequency **current** I_{AMP1}-I_{AMPN} (e.g., alternating currents) to help maintain a respective one of the modulated voltages V_{CC1}-V_{CCN} at a desired level. In this regard, each of the voltage amplifiers 32(1)-32(N) may generate a respective one of multiple sense currents I_{SENSE1}-I_{SENSEN} to indicate an amount of the respective one of the high-frequency **current** I_{AMP1}-I_{AMPN} that is sourced or sunk by the respective one of the voltage amplifiers 32(1)-32(N).

Each of the offset capacitors C_{OFF1}-C_{OFFN} is coupled between a respective one of the outputs 36(1)-36(N) and a respective one of the voltage outputs 18(1)-18(N). For example, the offset capacitor C_{OFF1} is coupled between the output 36(1) of the voltage amplifier 32(1) and the voltage output 18(1) of the voltage modulation circuit 16(1), and the offset capacitor C_{OFFN} is coupled between the output 36(N) of the voltage amplifier 32(N) and the voltage output 18(N) of the voltage modulation circuit 16(N). Each of the offset capacitors C_{OFF1}-C_{OFFN} **is configured to** raise a respective one of the modulated voltages V_{AMP1}-V_{AMPN} by a respective one of multiple offset voltages V_{OFF1}-V_{OFFN} to thereby generate a respective one of the modulated voltages V_{CC1}-V_{CCN} at a respective one of the voltage outputs 18(1)-18(N). For example, the offset capacitor C_{OFF1} is configured to raise the modulated initial voltage V_{AMP1} by the offset voltage V_{OFF1} to thereby generate the modulated voltage V_{CC1} (V_{CC1} = V_{AMP1} + V_{OFF1}) at the voltage output 18(1), and the offset capacitor C_{OFFN} is configured to raise the modulated initial voltage V_{AMPN} by the offset voltage V_{OFFN} to thereby generate the modulated voltage V_{CCN} (V_{CCN} = V_{AMPN} + V_{OFFN}) at the voltage output 18(N).

In one embodiment, the offset capacitors C_{OFF1}-C_{OFFN} can be configured to have an identical capacitance. In an alternative embodiment, the offset capacitors C_{OFF1}-C_{OFFN} can also be configured to have different capacitances. Further, the offset capacitors C_{OFF1}-C_{OFFN} can also be a same type or different types of capacitors.

The bypass switch S_{BYP} in each of the voltage modulation circuits 16(1)-16(N) is coupled between a respective one of the outputs 36(1)-36(N) and a ground (GND). For example, the bypass switch S_{BYP} in the voltage modulation circuit 16(1) is coupled between the output 36(1) of the voltage amplifier 32(1) and the GND, and the bypass switch S_{BYP} in the voltage modulation circuit 16(N) is coupled between the output 36(N) of the voltage amplifier 32(N) and the GND.

The on-off switch S_{ON-OFF} in each of the voltage modulation circuits 16(1)-16(N) is coupled between the common node 28 and a respective one of the voltage outputs 18(1)-18(N). For example, the on-off switch S_{ON-OFF} in the voltage modulation circuit 16(1) is coupled between the common node 28 and the voltage output 18(1) of the voltage modulation circuit 16(1), and the on-off switch S_{ON-OFF} in the voltage modulation circuit 16(N) is coupled between the common node 28 and the voltage output 18(N) of the voltage modulation circuit 16(N).

In an embodiment, the on-off switch S_{ON-OFF} in each of the voltage modulation circuits 16(1)-16(N) can be closed to provide a respective one of the low-frequency currents I_{DC1}-I_{DCN} from the common node 28 to a respective one of the voltage outputs 18(1)-18(N). In contrast, the on-off switch S_{ON-OFF} in each of the voltage modulation circuits 16(1)-16(N) can be opened to prevent the respective one of the low-frequency currents I_{DC1}-I_{DCN} from flowing from the common node 28 to the respective one of the voltage outputs 18(1)-18(N).

Each of the voltage modulation circuits 16(1)-16(N) further includes a respective one of multiple voltage feedback paths 38(1)-38(N). Each of the voltage feedback paths 38(1)-38(N) is configured to provide a respective one of multiple modulated voltage feedbacks V_{CC-FS1}-V_{CC-FBN} from a respective one of the voltage outputs 18(1)-18(N) to a respective input of the voltage amplifiers 32(1)-32(N). In this regard, each of the voltage modulation circuits 16(1)-16(N) is a closed-loop voltage modulation circuit.

Each of the voltage modulation circuits 16(1)-16(N) can be configured to generate and maintain a respective one of the modulated voltages V_{CC1}-V_{CCN} based on operations described below. Herein, operations of the voltage modulation circuit 16(1) are discussed as a non-limiting example. Understandably, the operation principles described with reference to the voltage modulation circuit 16(1) are applicable to any of the voltage modulation circuits 16(1)-16(N).

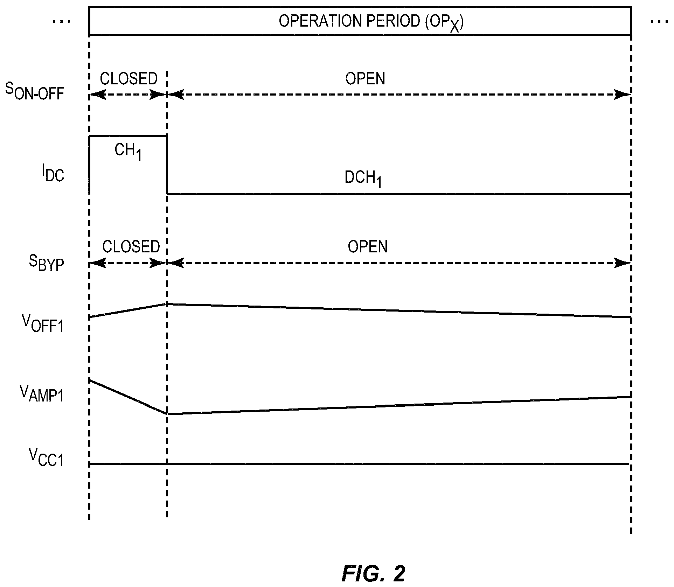

In essence, the voltage modulation circuit 16(1) can be configured to generate and maintain the modulated voltage V_{CC1} by toggling repeatedly between a charge interval and a discharge interval. Figure 2 illustrates an example operation of the voltage modulation circuit 16(1) for generating and maintain the modulated voltage V_{CC1} by toggling between a charge interval CH₁ and a discharge interval DCH₁ during an operation period OP_{X}. Common elements between Figures 1 and 2 are shown therein with common element numbers and will not be re-described herein.

During the charge interval CH₁, the control circuit 30 closes the on-off switch S_{ON-OFF} and the bypass switch S_{BYP} such that the low-frequency current I_{DC1} can flow from the common node 28 through the offset capacitor C_{OFF1} and to the GND to thereby charge the offset capacitor C_{OFF1} to the offset voltage V_{OFF1}. While the offset capacitor C_{OFF} is being charged, the control circuit 30 activates the voltage amplifier 32(1) to generate the modulated initial voltage V_{AMP1} to help maintain the modulated voltage V_{CC1} at a desired level.

Once the offset capacitor C_{OFF1} is charged up to the offset voltage V_{OFF1}, the voltage modulation circuit 16(1) will enter the discharge interval DCH₁. During the discharge interval DCH₁, the control circuit 30 opens the on-off switch S_{ON-OFF} and the bypass switch S_{BYP} concurrently. In this regard, the low-frequency current I_{DC1} is blocked from the common node and the offset capacitor C_{OFF1} is gradually discharged to maintain the modulated voltage V_{CC1} at the desired level.

As shown in Figure 2, during the charge interval CH₁, the voltage amplifier 32(1) may gradually reduce the modulated initial voltage V_{AMP1} as the offset capacitor C_{OFF1} is charged to gradually increase the offset voltage V_{OFF1}. In contrast, during the discharge interval DCH₁, the offset voltage V_{OFF1} will gradually decrease as the offset capacitor C_{OFF1} is discharged. Accordingly, the voltage amplifier 32(1) may gradually increase the modulated initial voltage V_{AMP1}. As such, the voltage modulation circuit 16(1) can maintain the modulated voltage V_{CC1} consistently at the desired level.

In an embodiment, the voltage amplifier 32(1) may source or sink the high-frequency current I_{AMP1} to help charge or discharge a holding capacitor (not shown) in the load circuit 20(1) to thereby help maintain the modulated voltage V_{CC1} at the desired level. In this regard, the voltage amplifier 32(1) will generate the sense current I_{SENSE1} to indicate the high-frequency current I_{AMP1} that is sourced or sunk by the voltage amplifier 32(1).

With reference back to Figure 1, each of the voltage modulation circuits 16(2)-16(N) can be configured to generate and maintain a respective one of the modulated voltages V_{CC2}-V_{CCN} by toggling repeatedly between a respective charge interval and a respective discharge interval as described above in the example of the voltage modulation circuit 16(1). In this regard, the control circuit 30 is configured to determine the respective charge interval and the respective discharge interval for each of the voltage modulation circuits 16(1)-16(N) such that the voltage modulation circuits 16(1)-16(N) can share the current modulation circuit 14 on a time-division basis.

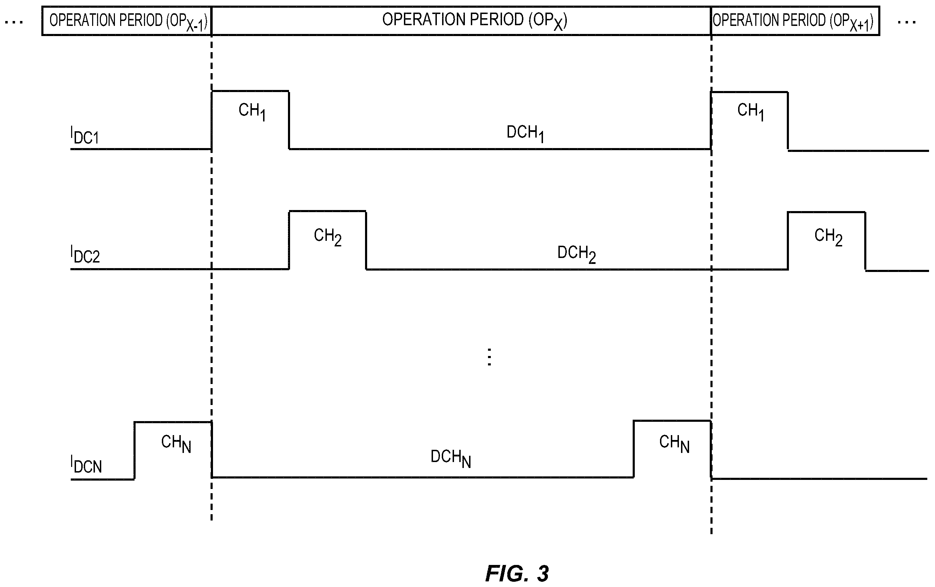

Figure 3 provides an example illustration of a time-division operation among the voltage modulation circuits 16(1)-16(N) in Figure 1. Common elements between Figures 1 and 3 are shown therein with common element numbers and will not be re-described herein.

Notably, the time-division operation is repeated in each of one or more operation periods OP_{X-1}, OP_{X}, OP_{X+1}. Notably, the operation periods OP_{X-1}, OP_{X}, OP_{X+1} are merely examples for the purpose of illustration. It should be appreciated that the time-division operation can be repeated over any number of operation periods as needed.

Specifically, during the operation period OP_{X}, the control circuit 30 determines multiple charge intervals CH₁-CH_{N} and multiple discharge intervals DCH₁-DCH_{N} for the voltage modulation circuits 16(1)-16(N), respectively. As shown in Figure 3, the charge intervals CH₁-CH_{N} are so determined not to overlap with one another. In contrast, the discharge intervals DCH₁-DCH_{N} may overlap with one another.

The charge intervals CH₁-CH_{N} can be of equal duration or different durations, depending on whether the offset capacitors C_{OFF1}-C_{OFFN} are having an identical capacitance or different capacitances. Specifically, when the offset capacitors C_{OFF1}-C_{OFFN} are having the identical capacitance, the charge intervals CH₁-CH_{N} can have an identical duration. In contrast, when the offset capacitors C_{OFF1}-C_{OFFN} are having different capacitances, the charge intervals CH₁-CH_{N} can have different durations. Regardless, a total duration of the charge intervals CH₁-CH_{N} shall be less than or equal to the duration of the operation period OP_{X}.

In this regard, each of the voltage modulation circuits 16(1)-16(N) toggles between a respective one of the charge intervals CH₁-CH_{N} and a respective one of the discharge intervals DCH₁-DCH_{N} to generate and maintain a respective one of the modulated voltages V_{CC1}-V_{CCN}. The voltage modulation circuits 16(1)-16(N) can make the modulated voltages V_{CC1}-V_{CCN} concurrently available to enable simultaneous operations of the load circuits 20(1)-20(N), despite operating based on the time-division scheme.

With reference back to Figure 1, since the modulated voltages V_{CC1}-V_{CCN} can be at different voltage levels, the control circuit 30 needs to adjust the duty cycles 26(1)-26(N) accordingly for each of the voltage modulation circuits 16(1)-16(N). According to an embodiment of the present disclosure, the control circuit 30 may determine the duty cycles 26(1)-26(N) for a respective one of the voltage modulation circuits 16(1)-16(N) based on one or more of: a respective one of the modulated initial voltages V_{AMP1}-V_{AMPN}, a respective one of the offset voltages V_{OFF1}-V_{OFFN}, a respective one of the modulated voltages V_{CC1}-V_{CCN}, and a respective one of the sense currents I_{SENSE1}-I_{SENSEN}.

Figure 4 is a schematic diagram providing an example illustration of the control circuit 30 in Figure 1 configured according to an embodiment of the present disclosure. Common elements between Figures 1 and 4 are shown therein with common element numbers and will not be re-described herein.

Herein, the control circuit 30 includes a first multiplexer 40, a second multiplexer 42, a third multiplexer 44, a fourth multiplexer 46, a first combiner 48, a second combiner 50, a third combiner 52, a controller 54, and a loop filter 56.

When determining a respective one of the duty cycles 26(1)-26(N) for a respective one of the voltage modulation circuits 16(1)-16(N), the first multiplexer 40 outputs a respective one of the modulated initial voltages V_{AMP1}-V_{AMPN}, the second multiplexer 42 outputs a respective one of the modulated voltages V_{CC1}-V_{CCN}, the third multiplexer 44 outputs a respective one of the offset voltages V_{OFF1}-V_{OFFN}, and the fourth multiplexer 46 outputs a respective one of the sense currents I_{SENSE1}-I_{SENSEN}.

The first combiner 48 combines the respective one of the modulated initial voltages V_{AMP1}-V_{AMPN} and the respective one of the modulated voltages V_{CC1}-V_{CCN} to output a first combined voltage V₁. The second combiner 50 combines the first combined voltage V₁ with the respective one of the offset voltages V_{OFF1}-V_{OFFN} to output a second voltage V₂. The loop filter 56 is configured to convert the second voltage V₂ into a first current I₁, which is combined with the respective one of the sense currents I_{SENSE1}-I_{SENSEN} at the third combiner 52 to generate a combined current I_{COMB}. The controller 54, which can be a bang-bang controller as an example, can then determine the respective one of the duty cycles 26(1)-26(N) for the respective one of the voltage modulation circuits 16(1)-16(N) based on the combined current I_{COMB}.

Notably, since the modulated voltages V_{CC1}-V_{CCN} can be different from one another in each of the operation periods OP_{X-1}, OP_{X}, OP_{X+1}, and so on, the current modulation circuit 14 needs to adapt the low-frequency currents I_{DC1}-I_{DCN} accordingly in each of the operation periods OP_{X-1}, OP_{X}, OP_{X+1}, and so on. As such, it is desirable to minimize an amount of current change (increase or decrease) between each of the low-frequency currents I_{DC1}-I_{DCN} to help improve efficiency of the current modulation circuit 14.

In this regard, the control circuit 30 can further include a scheduling circuit 58 to determine an order (also referred to as "current generation order") for generating the low-frequency currents I_{DC1}-I_{DCN} in each of the operation periods OP_{X-1}, OP_{X}, OP_{X+1}, and so on. Accordingly, the control circuit 30 can determine the duty cycles 26(1)-26(N) according to the determined current generation order to thereby cause the current modulation circuit 14 to generate the low-frequency currents I_{DC1}-I_{DCN} according to the determined current generation order.

In a non-limiting example, once the scheduling circuit 58 determines the current generation order for a respective one of the operation periods OP_{X-1}, OP_{X}, OP_{X+1}, and so on, the scheduling circuit 58 can control the first multiplexer 40, the second multiplexer 42, the third multiplexer 44, and the fourth multiplexer 46 via a selection signal 60. As such, the scheduling circuit 58 can cause the modulated initial voltages V_{AMP1}-V_{AMPN}, the modulated voltages V_{CC1}-V_{CCN}, the offset voltages V_{OFF1}-V_{OFFN}, and the sense currents I_{SENSE1}-I_{SENSEN} to be outputted from the first multiplexer 40, the second multiplexer 42, the third multiplexer 44, and the fourth multiplexer 46 in accordance with the determined current generation order. Accordingly, the control circuit 30 can generate the duty cycles 26(1)-26(N) in accordance with the determined current generation order.

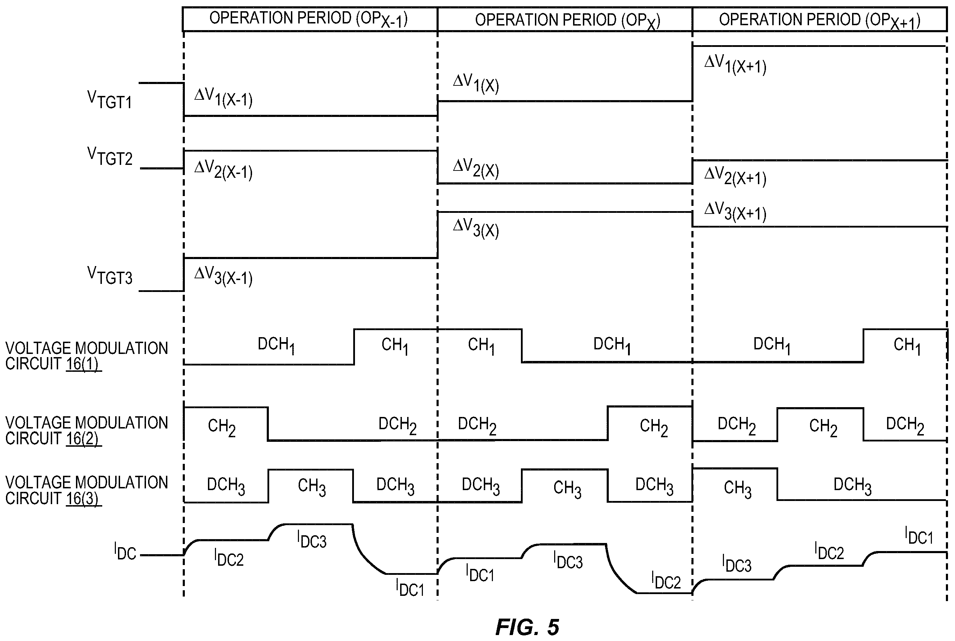

According to an embodiment of the present disclosure, the scheduling circuit 58 is configured to determine the current generation order (e.g., based on the modulated target voltages V_{TGT1}-V_{TGTN}) to minimize a relative change between each of the low-frequency currents I_{DC1}-I_{DCN} in each of the operation periods OP_{X-1}, OP_{X}, OP_{X+1}, and so on. In this regard, Figure 5 provides an example illustration as to how the control circuit 30 in Figure 4 can determine the charge intervals CH₁-CH_{N} and the discharge intervals DCH₁-DCH_{N} in Figure 3 based on the determined current generation order. For the sake of illustration, Figure 5 is described with reference to the voltage modulation circuits 16(1)-16(3) among the voltage modulation circuits 16(1)-16(N).

In one example, the scheduling circuit 58 receives the modulated target voltages V_{TGT1}, V_{TGT2}, and V_{TGT3} that indicate changes of the modulated voltages V_{CC1}, V_{CC2}, and V_{CC3} in the operation period OP_{X-1} relative to what were in a prior operation period (e.g., OP_{X-2}) are ΔV_{1(X-1)}, ΔV_{2(X-1)}, and ΔV_{3(X-1)}, respectively. The scheduling circuit 58 further determines that ΔV_{2(X-1)} < ΔV_{3(X-1)} < ΔV_{1(X-1)}. Accordingly, the scheduling circuit 58 can determine the current generation order in the operation period OP_{X-1} to be I_{DC2}, I_{DC3}, and I_{DC1}. In this regard, the control circuit 30 will generate the duty cycles 26(2), 26(3), and 26(1) to cause the current modulation circuit 14 to generate the low-frequency currents I_{DC2}, I_{DC3}, and I_{DC1}, respectively. Given the current generation order, the control circuit 30 will also determine the charge intervals CH₂, CH₃, and CH₁ in the operation period OP_{X-1} for charging the offset capacitors C_{OFF2}, C_{OFF3}, and C_{OFF1}, respectively. Upon determining the charge intervals CH₂, CH₃, and CH₁, the control circuit 30 can further determine the discharge intervals DCH₂, DCH₃, and DCH₁ accordingly.

In another example, the scheduling circuit 58 receives the modulated target voltages V_{TGT1}, V_{TGT2}, and V_{TGT3} that indicate changes of the modulated voltages V_{CC1}, V_{CC2}, and V_{CC3} in the operation period OP_{X} relative to what were in a prior operation period (e.g., OP_{X-1}) are ΔV_{1(X)}, ΔV_{2(X)}, and ΔV_{3(X)}, respectively. The scheduling circuit 58 further determines that ΔV_{1(X)} < ΔV_{3(X)} < ΔV_{2(X)}. Accordingly, the scheduling circuit 58 can determine the current generation order in the operation period OP_{X} to be I_{DC1}, I_{DC3}, and I_{DC2}. In this regard, the control circuit 30 will generate the duty cycles 26(1), 26(3), and 26(2) to cause the current modulation circuit 14 to generate the low-frequency currents I_{DC1}, I_{DC3}, and I_{DC2}, respectively. Given the current generation order, the control circuit 30 will also determine the charge intervals CH₁, CH₃, and CH₂ in the operation period OP_{X} for charging the offset capacitors C_{OFF1}, C_{OFF3}, and C_{OFF2}, respectively. Upon determining the charge intervals CH₁, CH₃, and CH₂, the control circuit 30 can further determine the discharge intervals DCH₁, DCH₃, and DCH₂ accordingly.

In another example, the scheduling circuit 58 receives the modulated target voltages V_{TGT1}, V_{TGT2}, and V_{TGT3} that indicate changes of the modulated voltages V_{CC1}, V_{CC2}, and V_{CC3} in the operation period OP_{X+1} relative to what were in a prior operation period (e.g., OP_{X}) are ΔV_{1(X+1)}, ΔV_{2(X+1)}, and ΔV_{3(X+1)}, respectively. The scheduling circuit 58 further determines that ΔV_{3(X+1)} < ΔV_{2(X+1)} < ΔV_{1(X+1)}. Accordingly, the scheduling circuit 58 can determine the current generation order in the operation period OP_{X+1} to be I_{DC3}, I_{DC2}, and I_{DC1}. In this regard, the control circuit 30 will generate the duty cycles 26(3), 26(2), and 26(1) to cause the current modulation circuit 14 to generate the low-frequency currents I_{DC3}, I_{DC2}, and I_{DC1}, respectively. Given the current generation order, the control circuit 30 will also determine the charge intervals CH₃, CH₂, and CH₁ in the operation period OP_{X+1} for charging the offset capacitors C_{OFF3}, C_{OFF2}, and C_{OFF1}, respectively. Upon determining the charge intervals CH₃, CH₂, and CH₁, the control circuit 30 can further determine the discharge intervals DCH₃, DCH₂, and DCH₁ accordingly.

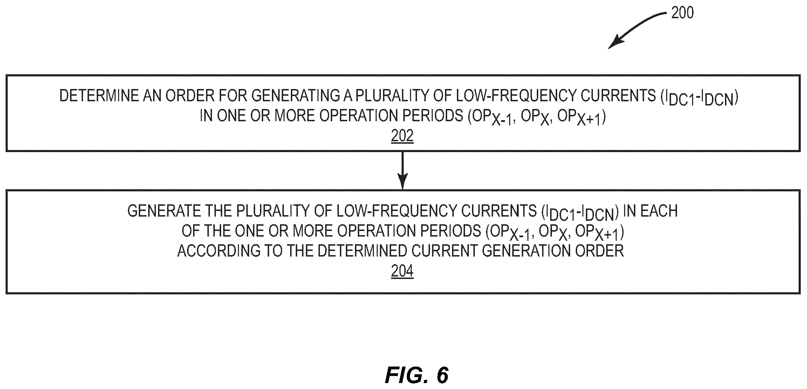

The multi-voltage generation circuit 12 in Figure 2 can be configured to generate the low-frequency currents I_{DC1}-I_{DCN} according to a process. In this regard, Figure 6 is a flowchart of an example process 200 for generating the low-frequency currents I_{DC1}-I_{DCN} to cause the multi-voltage generation circuit 12 in Figure 1 to generate and maintain the modulated voltages V_{CC1}-V_{CCN}.

Herein, the control circuit 30 is configured to determine an order (a.k.a. current generation order) for generating the low-frequency currents I_{DC1}-I_{DCN} in the operation periods OP_{X-1}, OP_{X}, OP_{X+1}, and so on (step 202). Accordingly, the current modulation circuit 14 can generate the low-frequency currents I_{DC1}-I_{DCN} in each of the operation periods OP_{X-1}, OP_{X}, OP_{X+1}, and so on according to the determined current generation order (step 204).

Thus, from one perspective, there has now been described a multi-voltage power generation circuit. More specifically, the multi-voltage generation circuit includes multiple voltage modulation circuits that are configured to generate and maintain multiple modulated voltages. In a non-limiting example, the multiple modulated voltages can be used for amplifying multiple radio frequency (RF) signals concurrently. Contrary to using multiple direct-current (DC) to DC (DC-DC) converters for generating the multiple modulated voltages, the voltage modulation circuits are configured to share a single current modulation circuit based on time-division. By sharing a single current modulation circuit among the multiple voltage modulation circuits, it is possible to concurrently support multiple load circuits (e.g., power amplifier circuits) with significantly reduced footprint.

Those skilled in the art will recognize improvements and modifications to the preferred embodiments of the present disclosure. All such improvements and modifications are considered within the scope of the concepts disclosed herein and the claims that follow.

## Claims

1. A multi-voltage generation circuit (12) comprising:
a current modulation circuit (14) configured to sequentially generate a plurality of low-frequency currents in each of one or more operation periods based on a plurality of duty cycles, respectively;
a plurality of voltage modulation circuits (16(1), 16(N)) each comprising:
a respective one of a plurality of voltage amplifiers configured to generate a respective one of a plurality of modulated initial voltages based on a respective one of a plurality of modulated target voltages; and
a respective one of a plurality of offset capacitors each modulated to a respective one of a plurality of offset voltages by a respective one of the plurality of low-frequency currents such that the respective one of the plurality of offset voltages can raise the respective one of the plurality of modulated initial voltages to thereby generate a respective one of a plurality of modulated voltages; and
a control circuit configured (30) to:
determine an order for generating the plurality of low-frequency currents in each of the one or more operation periods;
generate the plurality of duty cycles in accordance with the determined order; and
provide each of the plurality of duty cycles sequentially to the current modulation circuit to thereby cause the current modulation circuit to sequentially generate the plurality of low-frequency currents in each of the one or more operation periods according to the determined order.

2. The multi-voltage generation circuit of claim 1, wherein the control circuit is further configured to determine the order for generating the plurality of low-frequency currents to minimize a relative change between each of the plurality of low-frequency currents.

3. The multi-voltage generation circuit of claim 1 or claim 2, wherein the current modulation circuit comprises:
a multi-level charge pump (MCP) configured to operate based on a plurality of duty cycles to generate a plurality of low-frequency voltages each as a function of a battery voltage; and
a power inductor coupled between the MCP and a common node and configured to induce the plurality of low-frequency currents based on the plurality of low-frequency voltages, respectively.

4. The multi-voltage generation circuit of claim 3, wherein the control circuit is further configured to:
determine a plurality of charge intervals in each of the one or more operation periods in accordance with the determined order for generating the plurality of low-frequency currents; and
cause each of the plurality of offset capacitors to be charged to the respective one of the plurality of offset voltages during a respective one of the plurality of charge intervals.

5. The multi-voltage generation circuit of claim 4, wherein the control circuit is further configured to:
determine a plurality of discharge intervals each corresponding to a respective one of the plurality of charge intervals; and
cause each of the plurality of offset capacitors to be discharged to maintain the respective one of the plurality of modulated voltages during a respective one of the plurality of discharge intervals.

6. The multi-voltage generation circuit of claim 5, wherein each of the plurality of voltage modulation circuits further comprises:
a respective voltage output that outputs the respective one of the plurality of modulated voltages, wherein the respective one of the plurality of offset capacitors is coupled between a respective one of the respective one of the plurality of voltage amplifiers and the respective voltage output;
a respective bypass switch coupled between the respective output of the respective one of the plurality of voltage amplifiers and a ground; and
a respective on-off switch coupled between the power inductor and the respective voltage output.

7. The multi-voltage generation circuit of claim 6, wherein the control circuit is further configured to, for each of the plurality of voltage modulation circuits:
close the respective on-off switch during the respective one of the plurality of charge intervals to provide a respective one of the plurality of low-frequency currents from the common node to the respective voltage output;
close the respective bypass switch during the respective one of the plurality of charge intervals such that the respective one of the plurality of low-frequency currents can charge the respective one of the plurality of offset capacitors to the respective one of the plurality of offset voltages; and
cause the respective one of the plurality of voltage amplifiers to source or sink a respective high-frequency current during the respective one of the plurality of charge intervals to thereby maintain the respective one of the plurality of modulated voltages.

8. The multi-voltage generation circuit of claim 7, wherein the control circuit is further configured to, for each of the plurality of voltage modulation circuits:
open the respective on-off switch during the respective one of the plurality of discharge intervals to block the respective one of the plurality of low-frequency currents from flowing from the common node to the respective voltage output; and
open the respective bypass switch during the respective one of the plurality of discharge intervals such that the respective one of the plurality of offset capacitors is discharged to maintain the respective one of the plurality of modulated voltages.

9. The multi-voltage generation circuit of claim 7 or claim 8, wherein each of the plurality of voltage amplifiers is further configured to generate a respective one of a plurality of sense currents indicating a respective amount of the high-frequency current that is sourced/sunk by the respective one of the plurality of voltage amplifiers during the respective one of the plurality of charge intervals.

10. The multi-voltage generation circuit of claim 9, wherein the control circuit is further configured to determine each of the plurality of duty cycles based on one or more of:
the respective one of the plurality of modulated initial voltages;
the respective one of the plurality of offset voltages;
the respective one of the plurality of modulated voltages; and
the respective one of the plurality of sense currents.

11. A method for generating multiple low-frequency currents comprising:
determining (202) an order for generating a plurality of low-frequency currents in each of one or more operation periods;
generating a plurality of duty cycles in accordance with the determined order; and
sequentially generating (204) the plurality of low-frequency currents based on the plurality of duty cycles, respectively, in each of the one or more operation periods according to the determined order;
generating, using a respective of a plurality of voltage amplifiers, a respective one of a plurality of modulated initial voltages based on a respective one of a plurality of modulated target voltages; and
modulating a respective one of a plurality of offset capacitors coupled to the respective one of the plurality of voltage amplifiers by a respective one of the plurality of low-frequency currents such that the respective one of the plurality of offset voltages can raise the respective one of the plurality of modulated initial voltages to thereby generate a respective one of a plurality of modulated voltages.

12. The method of claim 11, further comprising determining the order to minimize a relative change between each of the plurality of low-frequency currents.

13. The method of claim 11 or claim 12, further comprising:
operating based on the plurality of duty cycles to generate a plurality of low-frequency voltages each as a function of a battery voltage; and
inducing the plurality of low-frequency currents based on the plurality of low-frequency voltages, respectively.

14. The method of claim 13, further comprising:
determining a plurality of charge intervals in each of the one or more operation periods in accordance with the determined order; and
charging a plurality of offset capacitors in the plurality of charge intervals based on the plurality of low-frequency currents, respectively;
optionally further comprising:
determining a plurality of discharge intervals each corresponding to a respective one of the plurality of charge intervals; and
discharging the plurality of offset capacitors in the plurality of discharge intervals, respectively.

15. A multi-voltage power management circuit (10) comprising:
a plurality of power amplifier circuits configured to concurrently amplify a plurality of radio frequency (RF) signals based on a plurality of modulated voltages, respectively; and
a multi-voltage generation circuit (12) according to claim 1.

## Patentansprüche

1. Mehrspannungserzeugungsschaltung (12), die Folgendes umfasst:
eine Strommodulationsschaltung (14), die dazu ausgelegt ist, sequenziell eine Vielzahl von Niederfrequenzströmen in jeder von einer oder mehreren Betriebsperioden basierend jeweils auf einer Vielzahl von Tastverhältnissen zu erzeugen;
eine Vielzahl von Spannungsmodulationsschaltungen (16(1), 16(N)), die jeweils Folgendes umfassen:
einen jeweiligen einer Vielzahl von Spannungsverstärkern, die dazu ausgelegt sind, eine jeweilige einer Vielzahl von modulierten Anfangsspannungen basierend auf einer jeweiligen einer Vielzahl von modulierten Zielspannungen zu erzeugen; und einen jeweiligen einer Vielzahl von Offset-Kondensatoren, die jeweils auf eine jeweilige einer Vielzahl von Offset-Spannungen durch einen jeweiligen der Vielzahl von Niederfrequenzströmen moduliert sind, so dass die jeweilige eine der Vielzahl von Offset-Spannungen die jeweilige eine der Vielzahl von modulierten Anfangsspannungen anheben kann, um dadurch eine jeweilige einer Vielzahl von modulierten Spannungen zu erzeugen; und
eine Steuerschaltung (30), die ausgelegt ist zum:
Bestimmen einer Reihenfolge zum Erzeugen der Vielzahl von Niederfrequenzströmen in jeder der einen oder der mehreren Betriebsperioden;
Erzeugen der Vielzahl von Tastverhältnissen gemäß der bestimmten Reihenfolge; und
Bereitstellen jedes der Vielzahl von Tastverhältnissen sequenziell an die Strommodulationsschaltung, um dadurch zu bewirken, dass die Strommodulationsschaltung sequenziell die Vielzahl von Niederfrequenzströmen in jeder der einen oder der mehreren Betriebsperioden gemäß der bestimmten Reihenfolge erzeugt.

2. Mehrspannungserzeugungsschaltung nach Anspruch 1, wobei die Steuerschaltung ferner dazu ausgelegt ist, die Reihenfolge zum Erzeugen der Vielzahl von Niederfrequenzströmen zu bestimmen, um eine relative Änderung zwischen jedem der Vielzahl von Niederfrequenzströmen zu minimieren.

3. Mehrspannungserzeugungsschaltung nach Anspruch 1 oder Anspruch 2, wobei die Strommodulationsschaltung Folgendes umfasst:
eine Multi-Level-Ladepumpe (MCP), die so ausgelegt ist, dass sie auf der Basis einer Vielzahl von Tastverhältnissen arbeitet, um eine Vielzahl von Niederfrequenzspannungen jeweils in Abhängigkeit von einer Batteriespannung zu erzeugen; und
eine Leistungsinduktivität, die zwischen der MCP und einem gemeinsamen Knoten gekoppelt ist und dazu ausgelegt ist, die Vielzahl von Niederfrequenzströmen jeweils basierend auf der Vielzahl von Niederfrequenzspannungen zu induzieren.

4. Mehrspannungserzeugungsschaltung nach Anspruch 3, wobei die Steuerschaltung ferner ausgelegt ist zum:
Bestimmen einer Vielzahl von Ladeintervallen in jeder der einen oder der mehreren Betriebsperioden gemäß der bestimmten Reihenfolge zum Erzeugen der Vielzahl von Niederfrequenzströmen; und
Bewirken, dass jeder der Vielzahl von Offset-Kondensatoren während eines jeweiligen der Vielzahl von Ladeintervallen auf die jeweilige eine der Vielzahl von Offset-Spannungen geladen wird.

5. Mehrspannungserzeugungsschaltung nach Anspruch 4, wobei die Steuerschaltung ferner ausgelegt ist zum:
Bestimmen einer Vielzahl von Entladeintervallen, die jeweils einem jeweiligen der Vielzahl von Ladeintervallen entsprechen; und
Bewirken, dass jeder der Vielzahl von Offset-Kondensatoren entladen wird, um die jeweilige eine der Vielzahl von modulierten Spannungen während eines jeweiligen der Vielzahl von Entladeintervallen aufrechtzuerhalten.

6. Mehrspannungserzeugungsschaltung nach Anspruch 5, wobei jede der Vielzahl von Spannungsmodulationsschaltungen ferner Folgendes umfasst:
einen jeweiligen Spannungsausgang, der die jeweilige eine der Vielzahl von modulierten Spannungen ausgibt, wobei der jeweilige eine der Vielzahl von Offset-Kondensatoren zwischen einem jeweiligen des jeweiligen einen der Vielzahl von Spannungsverstärkern und dem jeweiligen Spannungsausgang gekoppelt ist;
einen jeweiligen Bypass-Schalter, der zwischen dem jeweiligen Ausgang des jeweiligen einen der Vielzahl von Spannungsverstärkern und einer Masse gekoppelt ist; und einen jeweiligen Ein-Aus-Schalter, der zwischen der Leistungsinduktivität und dem jeweiligen Spannungsausgang gekoppelt ist.

7. Mehrspannungserzeugungsschaltung nach Anspruch 6, wobei die Steuerschaltung, für jede der Vielzahl von Spannungsmodulationsschaltungen, ferner ausgelegt ist zum:
Schließen des jeweiligen Ein-Aus-Schalters während des jeweiligen einen der Vielzahl von Ladeintervallen, um einen jeweiligen der Vielzahl von Niederfrequenzströmen vom gemeinsamen Knoten an den jeweiligen Spannungsausgang bereitzustellen;
Schließen des jeweiligen Bypass-Schalters während des jeweiligen einen der Vielzahl von Ladeintervallen, so dass der jeweilige eine der Vielzahl von Niederfrequenzströmen den jeweiligen einen der Vielzahl von Offset-Kondensatoren zu der jeweiligen einen der Vielzahl von Offset-Spannungen laden kann; und
Bewirken, dass der jeweilige eine der Vielzahl von Spannungsverstärkern einen jeweiligen Hochfrequenzstrom während des jeweiligen einen der Vielzahl von Ladeintervallen bezieht oder versenkt, um dadurch die jeweilige eine der Vielzahl von modulierten Spannungen aufrechtzuerhalten.

8. Mehrspannungserzeugungsschaltung nach Anspruch 7, wobei die Steuerschaltung, für jede der Vielzahl von Spannungsmodulationsschaltungen, ferner ausgelegt ist zum:
Öffnen des jeweiligen Ein-Aus-Schalters während des jeweiligen einen der Vielzahl von Entladeintervallen, um den Fluss des jeweiligen einen der Vielzahl von Niederfrequenzströmen vom gemeinsamen Knoten an den jeweiligen Spannungsausgang zu blockieren; und
Öffnen des jeweiligen Bypass-Schalters während des jeweiligen einen der Vielzahl von Entladeintervallen, so dass der jeweilige eine der Vielzahl von Offset-Kondensatoren entladen wird, um die jeweilige eine der Vielzahl von modulierten Spannungen aufrechtzuerhalten.

9. Mehrspannungserzeugungsschaltung nach Anspruch 7 oder Anspruch 8, wobei jeder der Vielzahl von Spannungsverstärkern ferner dazu ausgelegt ist, einen jeweiligen einer Vielzahl von Erfassungsströmen zu erzeugen, die eine jeweilige Menge des Hochfrequenzstroms angeben, der von dem jeweiligen einen der Vielzahl von Spannungsverstärkern während des jeweiligen einen der Vielzahl von Ladeintervallen bezogen/versenkt wird.

10. Mehrspannungserzeugungsschaltung nach Anspruch 9, wobei die Steuerschaltung ferner dazu ausgelegt ist, jedes der Vielzahl von Tastverhältnissen basierend auf einem oder mehreren von Folgendem zu bestimmen:
der jeweiligen einen der Vielzahl von modulierten Anfangsspannungen;
der jeweiligen einen der Vielzahl von Offset-Spannungen; der jeweiligen einen der Vielzahl von modulierten Spannungen; und
dem jeweiligen einen der Vielzahl von Erfassungsströmen.

11. Verfahren zum Erzeugen mehrerer Niederfrequenzströme, das Folgendes umfasst:
Bestimmen (202) einer Reihenfolge zum Erzeugen einer Vielzahl von Niederfrequenzströmen in jeder von einer oder mehreren Betriebsperioden;
Erzeugen einer Vielzahl von Tastverhältnissen gemäß der bestimmten Reihenfolge; und
sequenzielles Erzeugen (204) der Vielzahl von Niederfrequenzströmen jeweils basierend auf der Vielzahl von Tastverhältnissen in jeder der einen oder der mehreren Betriebsperioden gemäß der bestimmten Reihenfolge;
Erzeugen, unter Verwendung eines jeweiligen einer Vielzahl von Spannungsverstärkern, einer jeweiligen einer Vielzahl von modulierten Anfangsspannungen basierend auf einer jeweiligen einer Vielzahl von modulierten Zielspannungen; und
Modulieren eines jeweiligen einer Vielzahl von Offset-Kondensatoren, die mit dem jeweiligen einen der Vielzahl von Spannungsverstärkern gekoppelt sind, durch einen jeweiligen der Vielzahl von Niederfrequenzströmen, so dass die jeweilige eine der Vielzahl von Offset-Spannungen die jeweilige eine der Vielzahl von modulierten Anfangsspannungen anheben kann, um dadurch eine jeweilige einer Vielzahl von modulierten Spannungen zu erzeugen.

12. Verfahren nach Anspruch 11, das ferner Bestimmen der Reihenfolge zum Minimieren einer relativen Änderung zwischen jedem der Vielzahl von Niederfrequenzströmen umfasst.

13. Verfahren nach Anspruch 11 oder Anspruch 12, das ferner Folgendes umfasst:
Arbeiten basierend auf der Vielzahl von Tastverhältnissen, um eine Vielzahl von Niederfrequenzspannungen jeweils in Abhängigkeit von einer Batteriespannung zu erzeugen; und
Induzieren der Vielzahl von Niederfrequenzströmen jeweils basierend auf der Vielzahl von Niederfrequenzspannungen.

14. Verfahren nach Anspruch 13, das ferner Folgendes umfasst:
Bestimmen einer Vielzahl von Ladeintervallen in jeder der einen oder der mehreren Betriebsperioden gemäß der bestimmten Reihenfolge; und
Laden einer Vielzahl von Offset-Kondensatoren in der Vielzahl von Ladeintervallen jeweils basierend auf der Vielzahl von Niederfrequenzströmen;
optional ferner umfassend:
Bestimmen einer Vielzahl von Entladeintervallen, die jeweils einem jeweiligen der Vielzahl von Ladeintervallen entsprechen; und
Entladen der Vielzahl von Offset-Kondensatoren jeweils in der Vielzahl von Entladeintervallen.

15. Mehrspannungs-Leistungsverwaltungsschaltung (10), die Folgendes umfasst:
eine Vielzahl von Leistungsverstärkerschaltungen, die dazu ausgelegt sind, gleichzeitig eine Vielzahl von Hochfrequenz(HF)-Signalen basierend jeweils auf einer Vielzahl von modulierten Spannungen zu verstärken; und
eine Mehrspannungserzeugungsschaltung (12) nach Anspruch 1.

## Revendications

1. Circuit (12) de génération de tensions multiples comprenant :
un circuit (14) de modulation de courant configuré pour générer séquentiellement une pluralité de courants à basse fréquence respectivement dans chacune d'une ou de plusieurs périodes de fonctionnement sur la base d'une pluralité de cycles de service ;
une pluralité de circuits (16(1), 16(N)) de modulation de tension comprenant chacun :
un amplificateur respectif parmi une pluralité d'amplificateurs de tension, configuré pour générer une tension respective parmi une pluralité de tensions initiales modulées sur la base d'une tension respective parmi une pluralité de tensions cibles modulées ; et
un condensateur respectif parmi une pluralité de condensateurs de décalage, chacun modulé à une tension respective parmi une pluralité de tensions de décalage par un courant respectif parmi une pluralité de courants à basse fréquence de telle sorte que la tension respective parmi la pluralité de tensions de décalage puisse élever la tension respective parmi la pluralité de tensions initiales modulées pour ainsi générer une tension respective parmi une pluralité de tensions modulées ; et
un circuit de commande (30) configuré pour :
déterminer un ordre de génération de la pluralité de courants à basse fréquence dans chacune de la ou des périodes de fonctionnement ;
générer la pluralité de cycles de service selon un ordre déterminé ; et
fournir séquentiellement chacun de la pluralité de cycles de service au circuit de modulation de courant pour ainsi amener le circuit de modulation de courant à générer séquentiellement la pluralité de courants à basse fréquence dans chacune de la ou des périodes de fonctionnement selon l'ordre déterminé.

2. Circuit de génération de tensions multiples selon la revendication 1, le circuit de commande étant en outre configuré pour déterminer l'ordre de génération de la pluralité de courants à basse fréquence afin de minimiser une variation relative entre chacun de la pluralité de courants à basse fréquence.

3. Circuit de génération de tensions multiples selon la revendication 1 ou la revendication 2, le circuit de modulation de courant comprenant :
une pompe de charge multiniveau (MCP) configurée pour fonctionner sur la base d'une pluralité de cycles de service afin de générer une pluralité de tensions à basse fréquence, chacune en fonction d'une tension de batterie ; et
une inductance de puissance couplée entre le MCP et un nœud commun, et configurée pour induire la pluralité de courants à basse fréquence respectivement sur la base de la pluralité de tensions à basse fréquence.

4. Circuit de génération de tensions multiples selon la revendication 3, le circuit de commande étant en outre configuré pour :
déterminer une pluralité d'intervalles de charge dans chacune des périodes de fonctionnement selon l'ordre déterminé de génération de la pluralité de courants à basse fréquence ; et
amener chacun de la pluralité de condensateurs de décalage à se charger à la tension respective parmi la pluralité de tensions de décalage pendant un intervalle respectif parmi la pluralité d'intervalles de charge.

5. Circuit de génération de tensions multiples selon la revendication 4, le circuit de commande étant en outre configuré pour :
déterminer une pluralité d'intervalles de décharge correspondant chacun à un intervalle respectif parmi la pluralité d'intervalles de charge ; et
amener chacun de la pluralité de condensateurs de décalage à se décharger pour maintenir la tension respective parmi la pluralité de tensions modulées pendant un intervalle respectif parmi la pluralité d'intervalles de décharge.

6. Circuit de génération de tensions multiples selon la revendication 5, chacun de la pluralité de circuits de modulation de tension comprenant en outre :
une sortie de tension respective qui délivre la tension respective parmi la pluralité de tensions modulées, le condensateur respectif parmi la pluralité de condensateurs de décalage étant couplé entre un amplificateur respectif parmi la pluralité d'amplificateurs de tension et la sortie de tension respective ;
un commutateur de dérivation respectif couplé entre la sortie respective de l'amplificateur respectif parmi la pluralité d'amplificateurs de tension et une masse ; et
un commutateur marche/arrêt respectif couplé entre l'inductance de puissance et la sortie de tension respective.

7. Circuit de génération de tensions multiples selon la revendication 6, le circuit de commande étant en outre configuré, pour chacun de la pluralité de circuits de modulation de tension, pour :
fermer le commutateur marche/arrêt respectif pendant l'intervalle respectif parmi la pluralité d'intervalles de charge pour fournir un courant respectif parmi la pluralité de courants à basse fréquence depuis le nœud commun vers la sortie de tension respective ;
fermer le commutateur de dérivation respectif pendant l'intervalle respectif parmi la pluralité d'intervalles de charge de telle sorte que le courant respectif parmi la pluralité de courants à basse fréquence puisse charger le condensateur respectif parmi la pluralité de condensateurs de décalage à la tension respective parmi la pluralité de tensions de décalage ; et
amener l'amplificateur respectif parmi la pluralité d'amplificateurs de tension à fournir ou à absorber un courant à haute fréquence respectif pendant l'intervalle respectif parmi la pluralité d'intervalles de charge afin de maintenir ainsi une tension respective parmi la pluralité de tensions modulées.

8. Circuit de génération de tensions multiples selon la revendication 7, le circuit de commande étant en outre configuré, pour chacun de la pluralité de circuits de modulation de tension, pour :
ouvrir le commutateur marche/arrêt respectif pendant l'intervalle respectif parmi la pluralité d'intervalles de décharge pour empêcher le courant respectif parmi la pluralité de courants à basse fréquence de circuler depuis le nœud commun vers la sortie de tension respective ; et
ouvrir le commutateur de dérivation respectif pendant l'intervalle respectif parmi la pluralité d'intervalles de décharge de telle sorte que le condensateur respectif parmi la pluralité de condensateurs de décalage se décharge pour maintenir la tension respective parmi la pluralité de tensions modulées.

9. Circuit de génération de tensions multiples selon la revendication 7 ou la revendication 8, chacun de la pluralité d'amplificateurs de tension étant en outre configuré pour générer un courant respectif parmi une pluralité de courants de détection indiquant une quantité respective du courant à haute fréquence qui est fourni/absorbé par l'amplificateur respectif parmi la pluralité d'amplificateurs de tension pendant l'intervalle respectif parmi la pluralité d'intervalles de charge.

10. Circuit de génération de tensions multiples selon la revendication 9, le circuit de commande étant en outre configuré pour déterminer chacun de la pluralité de cycles de service sur la base d'une ou de plusieurs grandeurs parmi :
la tension respective parmi la pluralité de tensions initiales modulées ;
la tension respective parmi la pluralité de tensions de décalage ;
la tension respective parmi la pluralité de tensions modulées ; et
le courant respectif parmi la pluralité de courants de détection.

11. Procédé de génération de courants à basse fréquence multiples comprenant :
la détermination (202) d'un ordre de génération d'une pluralité de courants à basse fréquence dans chacune d'une ou de plusieurs périodes de fonctionnement ;
la génération d'une pluralité de cycles de service selon un ordre déterminé ; et
la génération séquentielle (204) de la pluralité de courants à basse fréquence sur la base de la pluralité de cycles de service respectivement dans chacune de la ou des périodes de fonctionnement selon l'ordre déterminé ;
la génération, à l'aide d'un amplificateur respectif parmi une pluralité d'amplificateurs de tension, d'une tension respective parmi une pluralité de tensions initiales modulées sur la base d'une tension respective parmi une pluralité de tensions cibles modulées ; et
la modulation d'un condensateur respectif parmi une pluralité de condensateurs de décalage couplés à l'amplificateur respectif parmi la pluralité d'amplificateurs de tension par un courant respectif parmi la pluralité de courants à basse fréquence de telle sorte que la tension respective parmi la pluralité de tensions de décalage puisse élever la tension respective parmi la pluralité de tensions initiales modulées pour ainsi générer une tension respective parmi une pluralité de tensions modulées.

12. Procédé selon la revendication 11, comprenant en outre la détermination de l'ordre afin de minimiser une variation relative entre chacun de la pluralité de courants à basse fréquence.

13. Procédé selon la revendication 11 ou la revendication 12, comprenant en outre :
un fonctionnement sur la base de la pluralité de cycles de service pour générer une pluralité de tensions à basse fréquence, chacune en fonction d'une tension de batterie ; et
l'induction de la pluralité de courants à basse fréquence respectivement sur la base de la pluralité de tensions à basse fréquence.

14. Procédé selon la revendication 13, comprenant en outre :
la détermination d'une pluralité d'intervalles de charge dans chacune de la ou des périodes de fonctionnement selon un ordre déterminé ; et
la charge d'une pluralité de condensateurs de décalage dans la pluralité d'intervalles de charge respectivement sur la base de la pluralité de courants à basse fréquence ;
comprenant en outre facultativement :
la détermination d'une pluralité d'intervalles de décharge correspondant chacun à un intervalle respectif parmi la pluralité d'intervalles de charge ; et
la décharge de la pluralité de condensateurs de décalage dans la pluralité d'intervalles de décharge, respectivement.

15. Circuit (10) de gestion de puissance à tensions multiples comprenant :
une pluralité de circuits amplificateurs de puissance configurés pour amplifier simultanément une pluralité de signaux radiofréquence (RF) sur la base d'une pluralité de tensions modulées, respectivement ; et
un circuit (12) de génération de tensions multiples selon la revendication 1.
